Europäisches Patentamt

European Patent Office

Office européen des brevets

(11) Publication number: **0 390 671**
**A2**

# EUROPEAN PATENT APPLICATION

(21) Application number: **90400832.3**

(51) Int. Cl.⁵: **C30B 15/00, C30B 29/06**

(22) Date of filing: **27.03.90**

(30) Priority: **31.03.89 JP 82840/89**

(43) Date of publication of application:
**03.10.90 Bulletin 90/40**

(84) Designated Contracting States:
**DE FR GB**

(71) Applicant: **SHIN-ETSU HANDOTAI COMPANY, LIMITED**
**4-2, Marunouchi 1-Chome**
**Chiyoda-ku Tokyo(JP)**

(72) Inventor: **Yokota, Shuji**
**787-2, Yanase**
**Annaka-shi, Gunma-ken(JP)**
Inventor: **Yamagshi, Hirotoshi**
**1721-3, Annaka**
**Annaka-shi, Gunma-ken(JP)**
Inventor: **Abe, Takao**
**477-19, Yanase**
**Annaka-shi, Gunma-ken(JP)**

(74) Representative: **Durand, Yves Armand Louis et al**
**CABINET WEINSTEIN 20, Avenue de Friedland**
**F-75008 Paris(FR)**

(54) Process for determination of concentrations of metal impurities in Czochralski single crystal silicon.

(57) In the Czochralski method comprising charging polycrystalline silicon in a quartz crucible, heating and melting the polycrystal, immersing a seed single crystal in the melt, pulling the single crystal from the melt as single crystal silicon, a process for determination of concentrations of metal impurities in Czochralski single crystal silicon, wherein the solidification ratio of the single crystal silicon is maintained at a level of at least 95% and the analysis is effected on the residual melt left in the quartz crucible.

EP 0 390 671 A2

# Process for determination of concentrations of metal impurities in Czochralski single crystal silicon

## BACKGROUND OF THE INVENTION

### 1. Field of the Invention:

This invention relates to a process for accurately determining the concentrations of metal impurities in Czochralski single crystal silicon.

### 2. Description of the Related Art:

As the conventional method for the direct determination of the concentrations of metal impuri ties in Czochralski single crystal silicon, there are known chemical analysis methods such as ICP method (induced coupled plasma method) or the AA method (atomic absorption method), and the neutron activation analysis (NAA) method. However, since the contents of metal impurities are extremely low, it is very difficult to determine the concentrations of impurities, except some metals such as Au, in the crystal even according to the NAA method. The finding was reported that since the segregation coefficients of metals were smaller than 1, the metal impurities were concentrated in the residual melt left after the pulling of single crystal silicon was over and impurities in the residual melt was concentrated enough for analysis by the NAA method(P. Schmit et al. , SOLID-STATE SCIENCE AND TECH., MARCH 1981, page 630). It is generally admitted that the neutron activation analysis gives a high detection limit However, in the analysis method taught by the above mentioned article, the quantity of the sample is limited, and the impurities in the residual melt are segregated during the solidification process resulting in uneven distributions of the impurities. Therefore, according to such conventional method, it is difficult to accurately determine the concentrations of metal impurities in the crystal.

## SUMMARY OF THE INVENTION

It is therefore an object of this invention to provide a process in which the concentrations of metal impurities in pulled Czochralski single crystal can be precisely determined with easiness.

In the Czochralski method comprising charging polycrystal line silicon into a quartz crucible, heating and melting the polycrystal, immersing a seed single crystal in the melt, pulling the single crystal from the melt as single crystal silicon, according to this invention, the above-mentioned object is attained by crystallizing at least 95% of the whole melt and effecting analysis on impurities of the residual melt left in the quartz crucible to determine the concentrations of metal impurities in the pulled Czochralski single crystal silicon.

The metal concentration is specifically calculated according to the following formula (a) (Pfann's equation) :

$$C = C_0 K(1-X)^{K-1} \qquad (a)$$

wherein C represents the metal concentration in single crystal, $C_0$ represents the metal concentration in initial charge, K represents the segregation coefficient, and X represents the solidification ratio.

Incidentally, values of the segregation coefficient were already reported (W. Zulehner et al ., Crystal 8, Silicon Chemical Etching, page 28).

In this invention, the solidification ratio of the silicon melt is at least 95% and preferably at least 99%. If the solidification ratio is too low, errors in the determination of the impurity concentrations become large. Accordingly, too low a solidification ratio is not preferable. Two advantages are attained by maintaining the solidification ratio of the silicon melt as single crystal silicon at a level of at least 95%. One advantage is that the impurities to be analysed are enriched in the silicon residual melt due to their segregation coefficients less than 1. Another advantage is that the residual melt is small quantities enough to be all put into analytical procedures and any sampling error from uneven impurity distribution in the melt can be effectively avoided.

It is most preferred that all of the residual melt be subjected to the analysis. However, even if the

2

residual melt is pulverized into powders, each having a size of several mm (preferably smaller than 5 mm) and suffi ciently mixed and a part of the pulverization product is subject to the analysis so as to reduce a load on the analysis without sacrifice of the analytical accuracy.

This invention will now be described in detail with reference to the following examples. Needless to say, this invention should by no means be limited by these examples.

## Example 1

In 40 kg of polycrystalline silicon was incorporated 0.96 mg of Cu powder (the expected concentration in the residual melt was 12 ppmw) , and the mixture was charged in a quartz crucible having a diameter of 16 inches. Single crystal silicon was pulled according to the Czochralski method. The amount of the residual melt was 80 g and the solidification ratio was 99.8%. The residual melt was solidified and cooled to room temperature. The solidified mass of the residual melt of silicon was separated from the quartz crucible and all of the mass was dissolved in a hydrofluoric acid/nitric acid (1/1) mixed liquid, and the solution was evaporated to dryness. Then, 2.0 cc of nitric acid was added to the residue and pure water was added to obtain a predetermined amount of a solution. The solution was subjected to ICP analysis only with respect to Cu. The obtained results are shown in Table 1. It was found that the analysis precision was as high as 93.3%.

Table 1

| Expected Concentration in Residual melt | Found Value | Precision |
|---|---|---|
| 12 ppmw | 11.2 ppmw | 93.3% |

## Example 2

A quartz crucible having a diameter of 16 inches was charged with 40 kg of polycrystalline silicon, and single crystal silicon was pulled according to the Czochralski method. The amount of the residual melt was 80 g, and the solidification ratio was 99.8%. The residual melt was solidified and cooled to room temperature, and the solidified mass of the residual melt of silicon was separated from the quartz crucible and all of the mass was dissolved in a hydrofluoric acid/nitric acid (1/1) mixed liquid, and the solution was evaporated to dryness. Then, 2.0 cc of nitric acid was added to the residue and pure water was added to form a predetermined amount of a solution. The solution was subjected to ICP to effect the chemical analysis. The obtained results are shown in Table 2. The concentrations at the shoulder of the single crystal silicon ingot based on the analysis values were calculated according to the above-mentioned formula (a), and the results of the calculation are shown in Table 3.

## Example 3

A quartz crucible having a diameter of 16 inches gas charged with 40 kg of polycrystalline silicon of another lot, and single crystal silicon was pulled according to the Czochralski method. The amount of the residual melt was 80 g, and the solidification ratio was 99.8%. The residual melt was solidified and cooled to room temperature, and the solidified mass of the residual melt of silicon was separated from the quartz crucible and all of the mass was dissolved in a hydrofluoric acid/nitric acid (1/1) mixed liquid. The solution was evaporated to dryness. Then, 2.0 cc of nitric acid was added to the residue and pure water was added to form a predetermined amount of a solution. The solution was subjected to ICP to effect the chemical analysis. The obtained results are shown in Table 2. The concentrations at the shoulder of the single crystal silicon ingot based on the analysis values were calculated according to the above-mentioned formula (a). The results of the calculation are shown in Table 3.

## Example 4

A quartz crucible having a diameter of 16 inches was charged with 40 kg of polycrystalline silicon of still another lot, and single crystal silicon was pulled according to the Czochralski method. The amount of the residual melt was 400 g, and the solidification ratio was 99.0%. The residual melt was solidified and cooled to room temperature. The solidified mass of the residual melt of silicon was separated from the quartz crucible and pulverized into cubes having a size of about 3mm, and 1/3 of the pulverization product was dissolved in a hydrofluoric acid/nitric acid (1/1) mixed liquid, and the solution was evaporated to dryness. Then, 2.0 cc of nitric acid was added to the residue and pure water was added to obtain a predetermined amount of a solution. The solution was subjected to ICP to effect the chemical analysis. The obtained results are shown in Table 2. The concentrations at the shoulder of the single crystal silicon ingot based on the analysis values were calculated according to the above-mentioned formula (a). The results of the calculation are shown in Table 3.

Table 2

| Element | Example 2 (ppmw) | Example 3 (ppmw) | Example 4 (ppmw) |
|---------|---------|---------|---------|
| Ti | 2.5 | 2.6 | 0.6 |
| Cr | 12.9 | 0.7 | 0.1 |
| Mn | 0.5 | < 0.02 | < 0.02 |
| Fe | 48.5 | 3.1 | 0.6 |
| Ni | 5.3 | 0.4 | 0.1 |
| Cu | 0.5 | 0.05 | 0.01 |
| Mo | < 0.3 | < 0.2 | < 0.2 |

Table 3

| Element | Segregation Co-efficient x $10^5$ | Example 2 (atoms/cm$^3$ x $10^9$) | Example 3 (atoms/cm$^3$ x $10^9$) | Example 4 (atoms/cm$^3$ x $10^9$) |
|---------|---------|---------|---------|---------|
| Ti | 0.9 | 0.7 | 0.7 | 0.8 |
| Cr | 2.8 | 9.8 | 0.5 | 0.4 |
| Mn | 1.0 | 0.1 | < 0.05 | < 0.03 |
| Fe | 0.8 | 9.8 | 0.6 | 0.5 |
| Ni | 3.0 | 3.8 | 0.3 | 0.4 |
| Cu | 40 | 6.1 | 0.5 | 0.5 |
| Mo | 0.0045 | < 0.0001 | < 0.0001 | < 0.0005 |

During the pulling of the single crystal, the silicon metal is contaminated by partial dissolving of the quartz crucible and also with impurities in the atmosphere in the pulling furnace, and therefore, according to this invention, the concentrations at the shoulder of the pulled single crystal ingot are estimated to be values slightly larger than the true values. However, the influences can practically be ignored based on the data shown in Table 1 or others not shown here.

## Claims

1. In the Czochralski method comprising charging polycrystalline silicon in a quartz crucible, heating and melting the polycrystal, immersing a seed single crystal in the melt, pulling the single crystal from the melt as single crystal silicon, a process for determination of concentrations of metal impurities in Czochralski single crystal silicon, characterized in that the sol idification ratio of the single crystal silicon is maintained at a level of at least 95% and the analysis is effected on the residual melt left in the quartz crucible.

2. A process for determination of concentrations of metal impurities in Czochralski single crystal silicon according to claim 1, characterized in that the solidification ratio of single crystal silicon is maintained at a level of at least 99%.

3. A process for determination of concentrations of metal impurities in Czochralski single crystal silicon according to claim 1 or 2, characterized in that all of the residual melt is analysed by the chemical analysis methods (ICP or AA)

4. A process for determination of concentrations of metal impurities in Czochralski single crystal silicon according to claim 1 or 2, characterized in that the residual melt is pulverized in a size smaller than 5mm and sufficiently mixed, and the analysis is effected on a part of the pulverized product.